# FASCICULE DE BREVET EUROPEEN

(11) **EP 2 203 875 B1**
(45) Date de publication et mention de la délivrance du brevet: **18.02.2015**
(21) Numéro de dépôt: 08870402.8
(22) Date de dépôt: 13.10.2008
(51) Int. Cl.: G06K 19/077

(54) **SUPPORT DE DISPOSITIF D'IDENTIFICATION RADIOFRÉQUENCE POUR PASSEPORT ET SON PROCÉDÉ DE FABRICATION**
EINBANDDECKEL FÜR EINEN REISEPASS MIT FUNKFREQUENZIDENTIFIZIERUNGSVORRICHTUNG UND HESTELLUNGSVERFAHREN DAFÜR
RADIOFREQUENCY IDENTIFICATION DEVICE FOR PASSPORT AND METHOD FOR MAKING SAME

(30) Priorité: 08.04.2008 FR 0801931; 11.10.2007 FR 0707143
(43) Date de publication de la demande: 07.07.2010
(73) Titulaire: ASK S.A., 06560 Valbonne (FR)
(72) Inventeur: HALOPE, Christophe, 06400 Cannes (FR); MAZABRAUD, Olivier, 06600 Antibes (FR)
(86) Numéro de dépôt international: PCT/FR2008/001435
(87) Numéro de publication internationale: WO 2009/087296

(56) Documents cités:
- FR-A- 2 782 821
- FR-A- 2 826 154
- FR-A- 2 877 462
- FR-A- 2 881 251
- US-A1- 2003 052 177
- US-A1- 2008 179 404

## Description

### Domaine technique

La présente invention concerne les dispositifs d'identification radiofréquence destinés à être intégrés à des objets tels que des documents de sécurité et concerne en particulier un support de dispositif d'identification radiofréquence pour passeport et son procédé de fabrication.

### Etat de la technique

Les dispositifs d'identification radiofréquence (RFID) sans contact sont de plus en plus utilisés pour l'identification des personnes circulant dans des zones à accès contrôlé ou transitant d'une zone à une autre. Un dispositif RFID sans contact est un dispositif constitué d'une antenne et d'une puce connectée aux bornes de l'antenne. La puce n'est généralement pas alimentée et reçoit son énergie par couplage électromagnétique entre l'antenne du lecteur et l'antenne du dispositif RFID, des informations sont échangées entre le dispositif RFID et le lecteur et en particulier les informations stockées dans la puce qui ont trait à l'identification du possesseur de l'objet sur lequel se trouve le dispositif RFID et son autorisation à pénétrer dans une zone à accès contrôlé.

Ainsi, les passeports peuvent incorporer des dispositifs RFID pour l'identification du possesseur du passeport. La mémoire de la puce contient des informations telles que l'identité du possesseur du passeport, son pays d'origine, sa nationalité, les visas des différents pays visités, les dates d'entrée, les restrictions de circulation, les éléments biométriques, etc.

Le dispositif RFID est généralement fabriqué indépendamment du passeport pour être incorporé ensuite par collage entre la couverture et la page de garde inférieure par exemple du passeport. Le dispositif RFID comprenant l'antenne et la puce connectés ensemble est intégré alors à un support en papier, en plastique ou autre (appelé communément en anglais « inlay »).

De tels supports comprennent en général au moins deux couches rigides entre lesquelles est inséré le dispositif RFID. L'inconvénient de tels supports est leur manque de flexibilité dû à leur structure multicouches.

Le document FR 2 826 154 A divulque une carte à puce sans contact, comprenant une antenne sur un support d'antenne en matériau fibreux.

### Exposé de l'invention

C'est pourquoi le but de l'invention est de remédier à ces inconvénients en proposant un dispositif RFID destiné à être incorporé dans un livret d'identité tel qu'un passeport, ayant de bonnes propriétés de flexibilité tout en assurant une connexion fiable entre le module de circuit intégré et l'antenne.

Un autre but de l'invention est de fournir une couverture de livret d'identité tel qu'un passeport intégrant un tel dispositif d'identification radiofréquence sans marque visible de la puce sur l'extérieur de la couverture.

L'objet de l'invention est donc un procédé de fabrication d'une couverture de livret d'identité muni d'un dispositif d'identification radiofréquence (RFID), le dispositif comprenant une antenne et une puce connectée à l'antenne, le procédé comprenant les étapes suivantes :
- réaliser une antenne comportant des plots de connexion sur un support en papier ou en papier synthétique,
- effectuer une cavité entre les plots de connexion de l'antenne,
- déposer de la matière diélectrique adhésive sur le support d'antenne à proximité des plots de connexion de l'antenne,
- les plots de connexion de ladite antenne ayant une forme concave ou creuse ou bien encore évidée à la manière d'un anneau de sorte que lesdits plots de matière adhésive sont placés à l'intérieur du creux formé par la forme concave ou à l'intérieur de l'évidement,
- positionner un module de circuit intégré sur le support, le module comportant des plages de contact et la puce connectée aux plages de contact à l'intérieur d'une encapsulation de manière à ce que les plages de contact du module soient en regard des plots de connexion de l'antenne et que l'encapsulation du module soit dans la cavité,
- déposer sur la face du support comprenant l'antenne au moins une couche de film thermo-adhésif,
- déposer sur la couche (ou les) couche (s) de film thermo-adhésif une couche de couverture,
- laminer ensemble la couche de support, la (ou les) couche(s) de film thermo-adhésif et la couche de couverture.

### Description brève des figures

Les buts, objets et caractéristiques de l'invention apparaîtront plus clairement à la lecture de la description qui suit faite en référence aux dessins dans lesquels :
La figure 1 représente une vue de dessus du support d'antenne et de l'antenne du dispositif RFID selon l'invention,
La figure 2 représente le support d'antenne et le module de circuit intégré selon une coupe D-D de la figure 1,
La figure 3 représente une vue de dessus du support d'antenne et de l'antenne du dispositif RFID selon une variante de l'invention,
La figure 4 représente le support d'antenne et le module de circuit intégré selon une coupe D-D de la figure 3,
La figure 5 représente en coupe les différentes couches constitutives de la couverture électronique selon l'invention selon un premier exemple de réalisation,
La figure 6 représente en coupe les différentes couches constitutives de la couverture électronique selon l'invention selon un second exemple de réalisation,
La figure 7 représente une coupe du support de dispositif RFID après lamination,
La figure 8 représente en coupe les différentes couches constitutives du support de dispositif RFID selon un premier exemple de réalisation d'une variante de l'invention,
La figure 9 représente en coupe les différentes couches constitutives du support de dispositif RFID selon un second exemple de réalisation de la variante de l'invention,
La figure 10 représente en coupe le support de dispositif RFID après la première étape de lamination selon la variante de l'invention,
La figure 11 représente en coupe les différentes couches constitutives du support de dispositif RFID selon la variante de l'invention,
La figure 12 représente deux supports de dispositif RFID selon l'invention et la couverture de livret d'identité.

### Description détaillée de l'invention

Selon la première étape du procédé de fabrication, une antenne est réalisée sur une couche de support 10. L'antenne comporte un ensemble de une ou plusieurs spires 12. Les spires sont réalisées par impression de type sérigraphie, flexographie, héliogravure, offset ou jet d' encre à partir d' encre conductrice de type encre époxy chargée de particules conductrices telles que par exemple d'argent ou d'or ou à partir d'un polymère conducteur. La couche de support 10 est en matériau tel que du papier ou du papier synthétique. Le papier est composé de fibres végétales réduites en pâte et a par conséquent une structure fibreuse. L'âme du papier a tendance à se délaminer lorsqu'elle est-soumise à des contraintes de cisaillement, tandis que le papier synthétique, non fibreux a une structure microporeuse et possède une faible densité. Comme le papier, le papier synthétique facilite l'opération de lamination réalisée à des températures de l'ordre de 160°C, puisqu'il est stable à ces températures contrairement aux matériaux film thermoplastiques tel que le PVC ou le PETG, il ne flue pas. Le papier synthétique utilisé est constitué d' une seule couche non orientée d'un polymère tel que du polyéthylène ou du polypropylène chargée en charges minérales entre 40 et 80%. Sa composition lui confère une faible densité de l'ordre de 0,57 g/cm³ grâce à son réseau microporeux. L'épaisseur de la couche de support est comprise entre 240 et 280 µm et de préférence est de 250 µm. Le support 10 comporte un évidement 11 correspondant à l'emplacement de la charnière du livret d'identité.

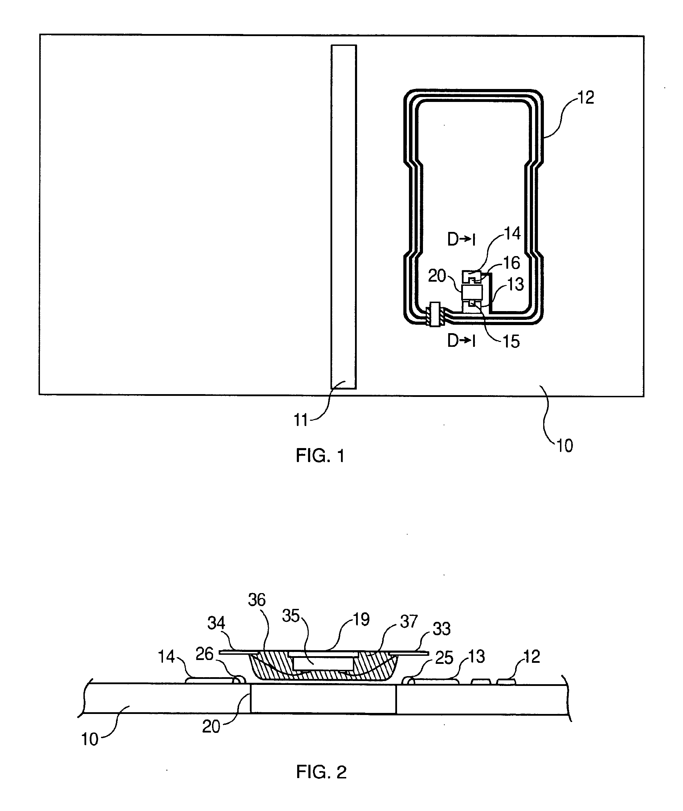

Selon la figure 2, un module de circuit intégré 19 comporte une puce 35, au moins deux plages de connexion 33 et 34. La connexion entre la puce et les plages 33 et 34 est réalisée par des fils conducteur ou câbles de connexions très petits 36, appelés « wire bonding » en anglais. La puce 35 et les fils sont encapsulés dans une résine de protection 37 à base d'un matériau résistant et ne conduisant pas l'électricité. L'encapsulation 37 est en quelque sorte une coque rigide qui vient englober la puce et son câblage de façon à la rendre moins fragile et davantage manipulable. L'encapsulation a une épaisseur comprise entre 200 et 240 µm. Le module présente ainsi sur sa face supérieure une surface plane correspondant à la partie supérieure de l'encapsulation 37 et sur sa face inférieure des plages de contact 33 et 34 destinées à venir se connecter à un circuit. Les plages 33 et 34 sont faites d'un matériau conducteur tel que de l'aluminium et leur épaisseur est comprise entre 70 et 100 µm.

Le module 19 représenté sur la figure 2 est destiné à venir se connecter à l'antenne sur des plots de connexion d'antenne. Dans le cadre de l'invention seuls deux plots de connexion 13 et 14 suffisent pour connecter le module. Les plots de connexion 13 et 14 sont la continuité de l'antenne par conséquent, ils sont dans le prolongement des spires de l'antenne et sont en général du même matériau que l'antenne. Les plots de connexion sont donc également réalisés par impression de type sérigraphie, flexographie, héliogravure, offset ou jet d'encre à partir d'encre conductrice de type encre époxy chargée de particules conductrices telles que par exemple d'argent ou d'or ou à partir d'un polymère conducteur. L'épaisseur des plots de connexion est comprise entre 5 et 10 µm.

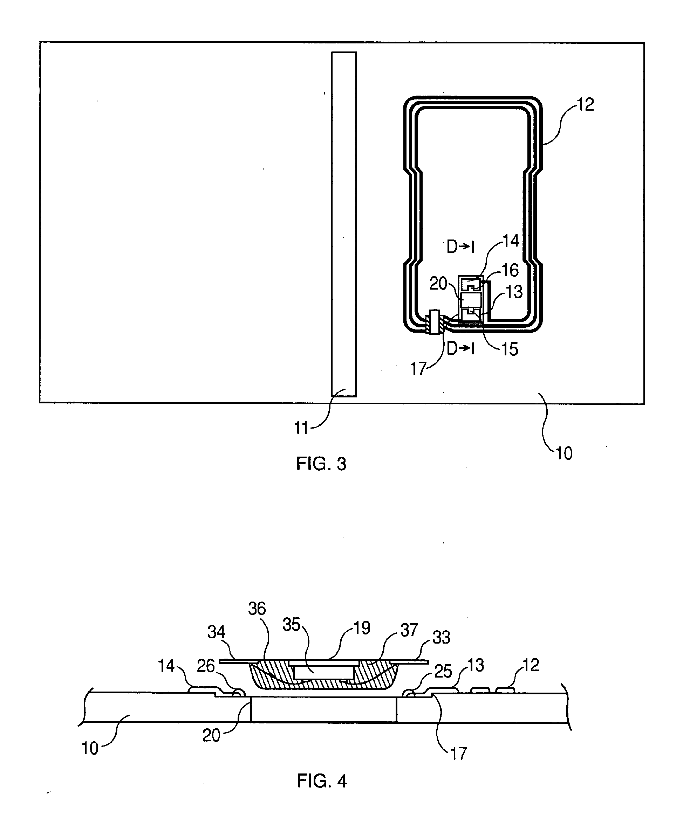

Selon une variante de l'invention représentée sur les figures 3 et 4, la couche de support 10 est embossée sur une épaisseur comprise entre 50 et 60 µm. L'étape d'embossage consiste à comprimer une partie de la couche de support 10 à l'aide d'une presse de sorte qu'elle garde ainsi l'empreinte de la presse. La forme de la presse utilisée est de telle sorte qu'elle laisse une empreinte rectangulaire 17 légèrement plus grande que le module. L'étape d'embossage est réalisée avant la réalisation de l'antenne. Toutes les étapes suivantes restent inchangées par rapport au procédé sans embossage, et en particulier la description de l'étape de mise en place du module qui va suivre est la même. L'épaisseur de la couche de support 10 dans ce cas est de préférence égale à 300 µm.

Le module 19 est collé sur la couche de support d'antenne 10 grâce à deux plots de matière adhésive 25 et 26 placés à côté des plots de connexion d'antenne de façon à ce que les plots de connexion 13 et 14 de l'antenne soient en regard des plages de contact 33 et 34 du module et que la partie encapsulée du module ou encapsulation 37 soit dans la cavité 20. Et en particulier, les plots de connexion 13 et 14 sont en regard de la partie des plages de contact 33 et 34 non recouverte de matière adhésive. La matière adhésive utilisée pour les plots 25 et 26 est une colle qui fixe uniquement le module à la couche de support 10 et comme cette colle n'est pas conductrice elle ne participe pas directement à la connexion électrique entre le module et l'antenne. La colle utilisée est de type cyanoacrylate. Les plots de colle sont placés sur la couche de support 10 à proximité des plots d'antenne de façon à ce que lorsque le module 19 est mis en place dans la cavité 20, la colle des plots est écrasée par les plages de contact du module jusqu'à ce que celles-ci rentrent en contact avec les plots d'antenne. Les plots de colle atteignent alors la même épaisseur que les plots d'antenne ou sensiblement la même et viennent effleurer les plots d'antenne. La proximité des plots de colle et des plots d'antenne garantit la fiabilité de la connexion électrique. Ainsi, dés la mise en place du module 19 dans la cavité 20, la connexion électrique est réalisée par la partie en contact des plages de contact du module et les plots de connexion 13 et 14 de l'antenne. Le support ainsi obtenu est un support d'antenne muni d'un module solidaire du support et connecté électriquement à l'antenne. De préférence, les plots de connexion de l'antenne ont une forme concave ou creuse ou bien encore évidée à la manière d'un anneau de sorte que les plots de matière adhésive sont placés à l'intérieur du creux de la forme concave ou à l'intérieur de l'évidement. Dans un mode de réalisation préférentiel de l'invention, les plots d'antenne sont en forme de U de sorte que les plots de matière adhésive sont placés à l'intérieur du U et sont donc entourés presque totalement des plots d'antenne.. La connexion électrique a ainsi l'avantage d'être réalisée sans soudure ni apport de matière.

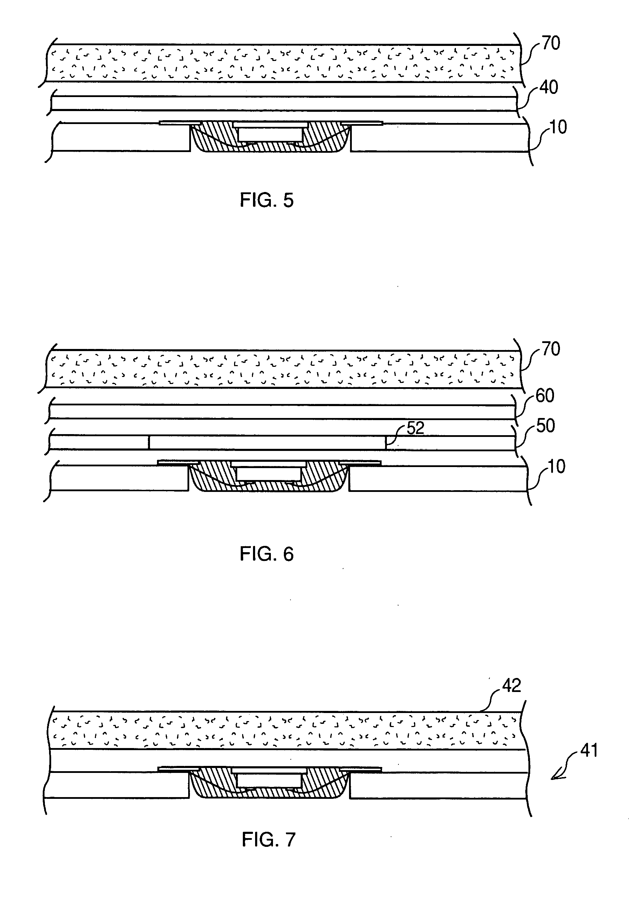

L'étape suivante du procédé est représentée sur les figures 5 et 6 selon deux modes différents. Dans un premier exemple de réalisation et en référence à la figure 5, une couche de film thermo-adhésif 40 est positionnée directement sur le support d'antenne du côté de l'antenne et sur la face inférieure du module. Une seconde couche 70 est positionnée sur la couche de film thermo-adhésif 40. Cette couche correspond à la couverture du livret d' identité et a une épaisseur d'environ 350 µm. La couche de couverture 70 a une base en papier ou en textile recouverte d'une couche de polyester, elle peut comporter sur sa face libre 72 un grain particulier la rendant infalsifiable. Cependant il est possible également de soumettre la face libre de la couverture du livret lors de la lamination ou ultérieurement à une plaque comportant des reliefs particuliers de façon à produire un grain particulier sur la couverture.

Dans un second exemple de réalisation de l'invention et en référence à la figure 6 une première couche de film thermo-adhésif 50 est positionnée directement sur le support d'antenne du côté de l'antenne et sur la partie inférieure du module. La couche 50 comporte une cavité 52 dont les dimensions sont voisines des dimensions de la surface totale du module. Ainsi, les bords de la cavité 52 épousent les bords extérieurs du module, plages de contact comprises. De cette façon, lorsque la couche 50 est en place sur la couche du support d'antenne 10, le module 19 se trouve dans la cavité 52. Une seconde couche 60 est positionnée sur la première couche 50. La couche 60 est également un film thermo-adhésif comportant de préférence les mêmes propriétés que la couche 50 et ne comportant pas de cavités. Une couche 70 est positionnée sur la couche de film thermo-adhésif 60. Les propriétés adhésives des couches de film thermo-adhésif 40, 50 et 60 sont activées sous l'action de la chaleur. Ces couches ont une épaisseur respective d'environ 50 µm.

Le premier exemple de réalisation correspondant à une seule couche de thermo-adhésif 40 est plus adapté au cas où la couche de support 10 est embossée à l'emplacement du module selon les figures 3 et 4. En effet, dans ce cas, les plages de contact du module sont en partie ou totalement noyées dans l'épaisseur de la couche de support 10 et par conséquent une seule couche de thermo-adhésif suffit à faire disparaitre le relief dû au module. Le second exemple de réalisation à deux couches de thermo-adhésif 50 et 60 est plus adapté au cas ou la couche de support n'est pas embossée. Cependant, cette préférence n' a pas un caractère limitatif.

Les couches référencées 10, 40 et 70 dans le cas du premier exemple de réalisation et 10, 50, 60 et 70 dans le cas du second exemple de réalisation sont assemblées entre elles par lamination. L'étape de lamination consiste à faire subir à l'ensemble des couches une montée en température jusqu'à 150°C et une montée en pression pouvant aller jusqu'à 0,5 Bars à quelques Bars (ce qui correspond à environ 10N/cm²) suivies d'une descente en température et d'une descente en pression, le tout selon un ensemble de cycles de durées définies. Lors de la lamination le film thermo-adhésif de la couche 40 du premier exemple et le film thermo-adhésif des couches 50 et 60 du second exemple se fluidifie et emprisonne l'antenne et le module dans la masse. La pression exercée lors de la lamination est dirigée perpendiculairement aux couches et donc perpendiculairement aux surfaces en contact des plages de contact 33 et 34 du module avec les plots de connexion 13 et 14 de l'antenne.

La figure 7 représente en coupe le module et les 3 couches de matériau différent après l'étape de lamination. Lors de l'étape de lamination les couches constitutives du support de dispositif RFID diminuent d'épaisseur. L'épaisseur totale des couches avant la lamination atteint 680 µm ce qui correspond dans le détail à la répartition suivante :
- Couverture 70 : 350 µm,
- deux films thermo-adhésifs de 40 µm,
- Couche de support 10 : 250 µm.
Après lamination le sandwich obtenu, appelé dans la suite de la description la couverture électronique, a une épaisseur comprise entre 640 µm et 650 µm.

Lors de la lamination une pression est exercée sur l'ensemble du module. Les plages de contact du module appuient sur les plots de connexion de l'antenne créant une déformation des plots de connexion et de la couche de support 10. Cette déformation est sous forme d'une empreinte dont la surface intérieure épouse exactement la surface extérieure des plages de connexion. Ainsi, il existe un contact intime entre les plages de contact 33 et 34 du module et l'encre conductrice des plots de connexion 13 et 14 sur une surface de contact maximale. Le matériau formant la couche de support 10 étant déformable et non élastique ainsi que l'encre conductrice des plots, ces deux matériaux n'ont pas tendance à reprendre leur forme d'origine même lorsque la pression cesse d'être exercée.

De plus, lors de la lamination, le film thermo-adhésif des couches 40 ou 50 et 60 ramollit et épouse complètement les contours de la face inférieur du module. Le film thermo-adhésif des couches 40 ou 50 et 60 agit comme une colle entre la couche de couverture 70 et la couche du support d'antenne 10 de sorte qu'une fois durcit il adhère complètement aux deux couches et au module. Les deux couches 10 et 70 de part et d'autre de la couche de film thermo-adhésif sont contraintes sous l'effet de la pression lors de la lamination et la contrainte exercée est maintenue sur les plages de contact du module de sorte que le contact électrique entre le module et l'antenne est permanent et fiable une fois que le film thermo-adhésif des couches 40 ou 50 et 60 a durcit.

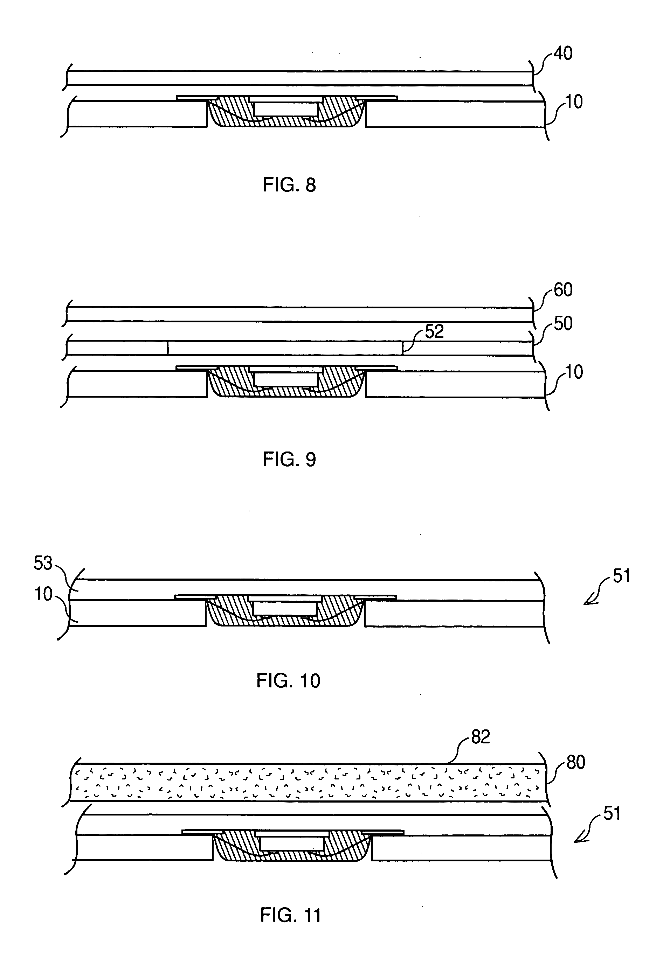

Un autre procédé de réalisation de l'invention, illustrée sur les figures 6 à 9 consiste à réaliser une première étape de pré-lamination avec les couches constitutives du support de dispositif RFID mais sans la couche de couverture 70. Cette pré-lamination consiste à activer partiellement la couche 40 ou les couches 50 et 60 de film thermo-adhésif afin de les « coller » au support d'antenne 10 et en gardant la possibilité de l'activer (ou les activer) de nouveau lors d'une autre étape de lamination. L'étape de pré-lamination consiste à faire subir à l'ensemble des couches une montée en température jusqu'à une température maximum comprise entre 50°C et 70°C en la maintenant pendant 3 minutes et une montée en pression. Lors de la pré-lamination le film thermo-adhésif de la couche 40 dans le premier exemple de la figure 8 et le film thermo-adhésif des couches 50 et 60 dans le second exemple de la figure 9 se fluidifie et emprisonne l'antenne et le module dans la masse. Le support de dispositif RFID 51 obtenu après cette étape de pré-lamination est un support d'antenne muni d'un module électronique connecté à l'antenne. Le support de dispositif RFID 51 comprend la couche 10 de support d'antenne et une couche 53 de thermo-adhésif correspondant à la couche 40 initiale ou aux couches 50 et 60 initiales de film thermo-adhésif. Une couche 80 est positionnée sur la couche de film thermo-adhésif 53. Les propriétés adhésives de la couche de film thermo-adhésif 53 sont ré-activées sous l'action de la chaleur. Donc les couches 10, 53 et 80 sont assemblées entre elles par lamination. Cette étape de lamination est similaire à celle décrite précédemment dans les figures 5 à 7. De la même façon, le contact électrique entre le module et l'antenne est permanent et fiable une fois que le film thermo-adhésif de la couche 53 a durcit.

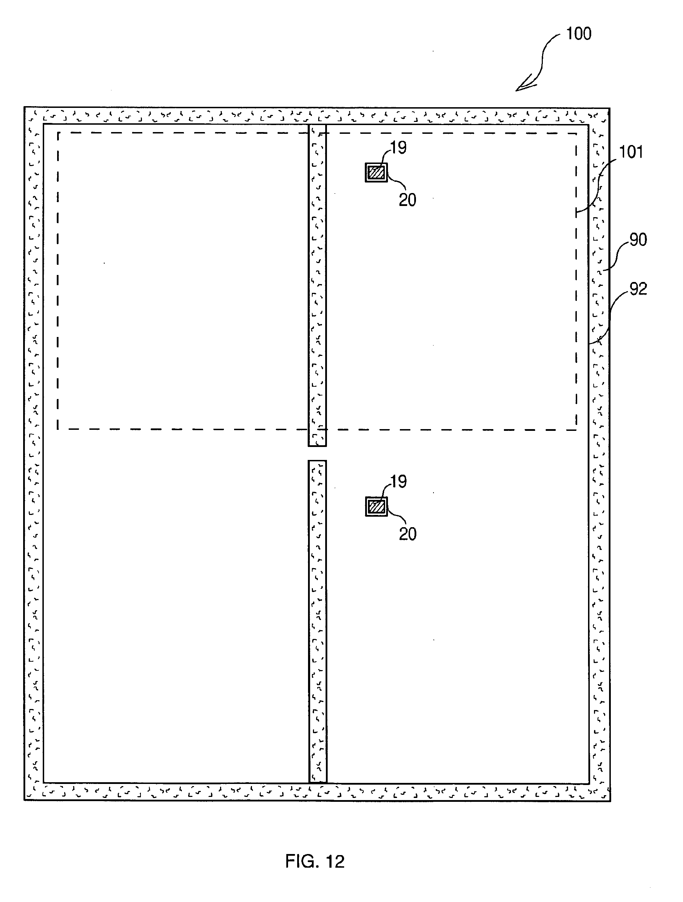

La figure 12 montre en vue de dessus un support 100 prévu pour servir de couverture muni d'un dispositif RFID à un ensemble de livret d'identité. Elle comporte une couche 90 de couverture dont la largeur est plus grande que la largeur d' un livret d'identité et la longueur pouvant contenir plusieurs support de dispositif RFID selon l'invention. On peut voir aussi une couche 92 correspondant à la couche support d'antenne en papier ou en papier synthétique et un ensemble de module 19 visible dans les cavités 20 de la couche 92. En pointillé sur la figure est représenté l'emplacement de la découpe d'une couverture de livret d'identité. Le livret d'identité est ensuite complètement formé par la mise en place du cahier des pages intérieures.

Les procédés de fabrication selon l'invention procurent un support de dispositif d'identification radiofréquence fiable et résistant. De plus, le grain de la couverture n'est pas abimé pendant les étapes de lamination.

## Revendications

1. Procédé de fabrication d'une couverture de livret d'identité muni d'un dispositif d'identification radiofréquence (RFID), ledit dispositif comprenant une antenne et un module de circuit intégré (19) connecté à l'antenne, ledit procédé comprenant les étapes suivantes :
- réaliser une antenne (12) comportant des plots de connexion (13 et 14) sur un support (10) en papier ou en papier synthétique,
- effectuer une cavité (20) entre les plots de connexion (13 et 14) de l'antenne,
- déposer de la matière diélectrique adhésive (25, 26) sur le support d'antenne (10) à proximité desdits plots de connexion de l'antenne,
- lesdits plots de connexion (13, 14) de l'antenne ayant une forme concave ou creuse ou bien encore évidée à la manière d'un anneau de sorte que lesdits plots (25, 26) de matière adhésive sont placés à l'intérieur du creux formé par la forme concave ou à l'intérieur de l'évidement,
- positionner le module de circuit intégré (19) sur ledit support, ledit module comportant des plages de contact (33, 34) et une puce (12) connectée aux plages de contact à l'intérieur d'une encapsulation (37) de manière à ce que les plages de contact dudit module soient en regard desdits plots de connexion de ladite antenne et que l'encapsulation du module soit dans la cavité (20),
- déposer sur la face dudit support comprenant l'antenne au moins une couche de film thermo-adhésif (40, 50, 60),
- déposer sur la couche (ou les) couche (s) (40 ou 50 et 60) de film thermo-adhésif une couche de couverture (70),
- laminer ensemble la couche de support (10), la (ou les) couche (s) (40 ou 50 et 60) de film thermo-adhésif et la couche de couverture (70).

2. Procédé selon la revendication 1 dans lequel une étape préliminaire à l'étape de réalisation de l'antenne consiste à embosser sur une épaisseur comprise entre 50 et 60 µm une partie de ladite couche de support (10) à l'endroit de l'emplacement du module, l'embossage ainsi réalisé étant de forme légèrement plus grande que le module.

3. Procédé selon la revendication 1 ou 2, **caractérisé en ce que** la couche de film thermo-adhésif directement appliquée sur le support d'antenne (10) est muni d'une cavité (20) à l'endroit du module (19), la forme de la cavité (20) est telle qu'elle épouse les bords de la face inférieure du module.

4. Procédé selon la revendication 1, 2 ou 3, dans lequel la matière adhésive (25, 26), déposée sur la couche de support d'antenne (10) est une colle cyanoacrylate.

5. Procédé selon l'une des revendications précédentes dans lequel lesdits plots de connexion de l'antenne sont en forme de U et la dépose de la matière diélectrique adhésive est faite à l'intérieur des U.

6. Procédé selon l'une des revendications précédentes dans lequel le papier synthétique dudit support (10) est fait d'un matériau qui ne flue pas c'est à dire qui ne se déforme pas lorsque la température augmente.

7. Procédé selon l'une des revendications précédentes dans lequel lesdites couches de film thermo-adhésif ont une épaisseur de 50 µm.

8. Procédé selon l'une des revendications précédentes dans lequel ladite antenne 12 est réalisée par impression de type sérigraphie à partir d'encre conductrice.

9. Couverture de livret d'identité muni d'un dispositif RFID comprenant :
- Une antenne (12) munie de deux plots de connexion (13, 14) réalisée sur un support (10) en papier ou en papier synthétique percé d'une cavité (20) située entre les plots (13, 14),
- Un module de circuit intégré (19) connecté à ladite antenne collé sur le support (10) grâce à deux plots (25, 26) de matière adhésive ;
Ledit module comportant des plages de contact (33, 34) et une puce (35) connectée auxdites plages de contact (33, 34) à l'intérieur d'une encapsulation (37), ledit module étant positionné de manière à ce que lesdites plages de contact dudit module soient en regard desdits plots de connexion de ladite antenne et que l'encapsulation du module soit dans ladite cavité (20) ;
Lesdits plots de connexion (13, 14) de ladite antenne (12) ayant une forme concave ou creuse ou bien encore évidée à la manière d'un anneau de sorte que les plots (25, 26) de matière adhésive sont situés à l'intérieur du creux formé par la forme concave ou à l'intérieur de l'évidement.

10. Couverture de livret selon la revendication 9, dans lequel ladite couche de support (10) est embossée à l'emplacement dudit module (19) de circuit intégré.

## Patentansprüche

1. Verfahren zur Herstellung eines Einbanddeckels für einen Reisepass, der mit einer Funkfrequenzidentifizierungsvorrichtung (RFID) versehen ist, wobei die Vorrichtung eine Antenne und ein integriertes Schaltungsmodul (19), das an die Antenne angeschlossen ist, umfasst, wobei das Verfahren die folgenden Schritte umfasst;
- Herstellen einer Antenne (12), umfassend Anschlussstücke (13 und 14) auf einem Träger (10) aus Papier oder synthetischem Papier,
- Herstellen eines Hohlraums (20) zwischen den Anschlussstücken (13 und 14) der Antenne,
- Aufbringen von haftendem dielektrischen Material (25, 26) auf den Antennenträger (10) in der Nähe der Anschlussstücke der Antenne,
- wobei die Anschlussstücke (13, 14) der Antenne eine konkave oder hohle oder auch in der Art eines Ringes ausgenommene Form haben, so dass die Stücke (25, 26) aus Haftmaterial im Inneren des Hohlraums, der durch die konkave Form gebildet ist, oder im Inneren der Aussparung angeordnet sind,
- Positionieren des integrierten Schaltungsmoduls (19) auf dem Träger, wobei das Modul Kontaktbereiche (33, 34) und einen Chip (12), der an die Kontaktbereiche im Inneren einer Verkapselung (37) angeschlossen ist, umfasst, so dass die Kontaktbereiche des Moduls den Anschlussstücken der Antenne gegenüber liegen, und dass die Verkapselung des Moduls in dem Hohlraum (20) ist,
- Aufbringen mindestens einer Schicht einer Thermohaftfolie, (40, 50, 60) auf die Fläche des Trägers, umfassend die Antenne,
- Aufbringen einer Abdeckschicht (70) auf die Schicht(en) (40 oder 50 und 60) der Thermohaftfolie,
- Laminieren der Trägerschicht (10), der Schicht (en) (40 oder 50 und 60) der Thermohaftfolie und der Abdeckschicht (70) aufeinander.

2. Verfahren nach Anspruch 1, bei dem ein Vorschritt zu dem Schritt des Herstellens der Antenne darin besteht, auf einer Dicke zwischen 50 und 60 µm einen Teil der Trägerschicht (10) an der Stelle der Anordnung des Moduls zu prägen, wobei die so hergestellte Prägung eine etwas größere Form als das Modul aufweiset.

3. Verfahren nach Anspruch 1 oder 2, **dadurch gekennzeichnet, dass** die Schicht der Thermohaftfolie, die direkt auf den Antennenträger (10) aufgebracht wird, mit einem Hohlraum (20) an der Stelle des Moduls (19) versehen ist, wobei die Form des Hohlraums (20) derart ist, dass sie sich an die Ränder der Innenseite des Moduls anlegt.

4. Verfahren nach Anspruch 1, 2 oder 3, bei dem das Haftmaterial (25, 26), das auf die Antennenträgerschicht (10) aufgebracht wird, ein Zyanacrylatklebstoff ist.

5. Verfahren nach einem der vorhergehenden Ansprüche, bei dem die Anschlusaatücke der Antenne eine U-Form haben und das Aufbringen des dielektrischen Haftmaterials im Inneren des U erfolgt.

6. Verfahren nach einem der vorhergehenden Ansprüche, bei dem das synthetische Papier des Trägers (10) aus einem Material besteht, das nicht fließt, d.h. das sich nicht verformt, wenn die Temperatur steigt.

7. Verfahren nach einem der vorhergehenden Ansprüche, bei dem die Schichten der Thermohaftfolie eine Dicke von 50 µm haben.

8. Verfahren nach einem der vorhergehenden Ansprüche, bei dem die Antenne (12) durch serigraphischen Druck aus leitender Tinte hergestellt ist.

9. Einbanddeckel für einen Reisepass, der mit einer RFID-Vorrichtung versehen ist, umfassend:
- eine Antenne (12), die mit zwei Anschlussstücken (13, 14) versehen und auf einem Träger (10) aus Papier oder synthetischem Papier hergestellt ist, der einen Hohlraum (20) aufweist, der sich zwischen den Stücken (13, 14) befindet,
- ein integriertes Schaltungsmodul (19), das an die Antenne angeschlossen und auf den Träger (10) durch zwei Stücke (25, 26) aus haftendem Material geklebt ist;
wobei das Modul Kontaktbereiche (33, 34) und einen Chip (35), der an die Kontaktbereiche (33, 34) im Inneren einer Verkapselung (37) angeschlossen ist, umfasst, wobei das Modul derart positioniert ist, dass die Kontaktbereiche des Moduls den Anschlussstücken der Antenne gegenüber liegen, und dass die Verkapselung des Moduls in dem Hohlraum (20) angeordnet ist;
wobei die Anschlussstücke (13, 14) der Antenne (12) eine konkave oder hohle oder auch in der Art eines Ringes ausgenommene Form haben, so dass sich die Stücke (25, 26) aus haftendem Material im Inneren des Hohlraums, der durch die konkave Form gebildet ist, oder im Inneren der Aussparung befinden.

10. Einbanddeckel nach Anspruch 9, bei dem die Trägerschicht (10) an der Stelle des integrierten Schaltungsmoduls (19) geprägt ist.

## Claims

1. A method for manufacturing and identity booklet cover provided with a radio frequency identification device (RFID), said device featuring an antenna and an integrated circuit module (19) connected to the antenna, said method including the following steps:
- producing an antenna (12) having contacts (13 and 14) on a support (10) made of paper or synthetic paper,
- creating a recess (20) between the contacts (13 and 14) of the antenna,
- placing adhesive dielectric material (25, 26) on the antenna support (10) near said antenna contacts,
- the said antenna contacts (13 and 14) having a concave or hollow shape or are hollowed out like a ring so that the said contacts of adhesive material (25, 26) are placed inside the hollow part of the concave shape or inside the recess,
- positioning an integrated circuit module (19) on said support, said module featuring groups of contacts (33, 34) and the chip connected to groups of contacts inside an encapsulation (37) of the module, so that the groups of contacts of said module are opposite said contacts of said antenna and the module is encapsulated into the recess (20),
- placing on the face of said support featuring the antenna at least one layer of thermo-adhesive film (40, 50, 60),
- placing a cover layer (70) on the layer (or) layer(s) (40 or 50 and 60) of thermo-adhesive film,
- laminating together the support layer (10), the layer (or) layer(s) (40 or 50 and 60) of thermo-adhesive film and the cover layer (70).

2. The method according to claim 1 in which a step preliminary to the manufacturing step of the antenna consists in embossing on a thickness between 50 and 60 µm a portion of said support layer (10) at the location of the module, the embossing thus created being of a shape slightly larger than the module.

3. The method according to claim 1 or 2, **characterized in that** the layer of thermo-adhesive film directly applied on the antenna support (10) is provided with a recess (20) at the location of the module (19), the shape of the recess (20) is such that it matches the edges of the lower face of the module.

4. The method according to any of claims 1, 2 or 3 in which the adhesive material (25, 26) applied to the antenna support layer (10) is a cyanoacrylate glue.

5. The method according to any of the previous claims in which said antenna contacts are U-shaped and the adhesive dielectric material is placed inside the U.

6. The method according to any one of the previous claims in which the synthetic paper of said support (10) is made of a material that does not creep i.e. which does not deform when the temperature increases.

7. The method according to any of the previous claims in which said layers of thermo-adhesive film have a thickness of 50 µm.

8. The method according to any of the previous claims in which said antenna 12 is made by screen printing using conductive ink.

9. Identity booklet cover provided with a radio frequency identification device (RFID) comprising:
- an antenna (12) provided with two contacts (13, 14) produced on a support layer (10) made of paper or synthetic paper with a recess located between the antenna contacts (13, 14),
- an integrated circuit module (19) connected to the antenna glued on the antenna support layer (10) by means of two contacts of adhesive material (25, 26);
The said module features two groups of contacts (33, 34) and a chip (35) connected to group of contacts inside an encapsulation (37), the said module being placed so that the said contacts of the antenna are opposite the groups of contacts of the module and so that the encapsulation (37) is in the recess (20);
the said antenna contacts (13, 14) having a concave or hollow shape or are hollowed out like a ring so that the said contacts of adhesive material (25, 26) are placed inside the hollow part of the concave shape or inside the recess.

10. Identify booklet cover according to claim 9, in which the support layer (10) is embossed at the location of the module.
